# EUROPEAN PATENT APPLICATION

(11) **EP 4 202 963 A1**
(43) Date of publication of application: **28.06.2023**
(21) Application number: 22201860.8
(22) Date of filing: 17.10.2022
(51) Int. Cl.: H01G 4/38, H01L 21/302, H01L 21/3213, H01L 21/768, H01L 27/02, H01L 29/66, H01L 29/94, H01G 4/012, H01G 4/33, H01G 4/248, H01G 4/40, H01G 4/228, H01G 4/08, H01G 4/10, H01G 4/12

(54) **ELECTRICALLY COUPLED TRENCH CAPACITORS WITHIN A SUBSTRATE AND A METHOD OF THEIR PRODUCTION**

(30) Priority: 22.12.2021 US 202117559847
(71) Applicant: INTEL Corporation, Santa Clara, CA 95054 (US)
(72) Inventor: ALEKSOV, Aleksandar, Chandler, 85286 (US); TANAKA, Hiroki, Gilbert, 85295 (US); DARMAWIKARTA, Kristof, Chandler, 85249 (US)
(74) Representative: Goddar, Heinz J.

(57) **Abstract**

Embodiments herein relate to systems, apparatuses, or processes directed to electrically coupled trench capacitors within a substrate. The substrate may be part of an interposer, such as a glass interposer, where the trench capacitors deliver a high capacitance density close to one or more dies that are attached to a surface of the substrate. Portions of the trench capacitor may be a thin film capacitor at a surface of the substrate. The trenches extend from a first side of the substrate toward a second side of the substrate opposite the first side. Other embodiments may be described and/or claimed.

## Description

### FIELD

Embodiments of the present disclosure generally relate to the field of package assemblies, and in particular to packages that include capacitors.

### BACKGROUND

Continued reduction in the size of mobile electronic devices, such as smart phones and ultrabooks, is a driving force for reducing package sizes and increasing the speed of components within packages.

### BRIEF DESCRIPTION OF THE DRAWINGS

FIG. 1 illustrates a cross section side view of a substrate that includes electrically coupled trench capacitors, in accordance with various embodiments.
FIG. 2 illustrates a perspective view of a substrate with various trench etchings, in accordance with various embodiments.
FIG. 3 illustrates a cross section side view of layers within a single trench, in accordance with various embodiments.
FIG. 4 illustrates cross section side views of electrical coupling structures used with electrically coupled trench capacitors, in accordance with various embodiments.
FIG. 5 illustrates a cross-section top view of a substrate that includes trench capacitors coupled with a conductive layer, in accordance with various embodiments.
FIG. 6 illustrates a cross-section top view of a substrate that includes electrically coupled trench capacitors, in accordance with various embodiments.
FIG. 7 illustrates an example process for manufacturing an interposer, in accordance with various embodiments.
FIG. 8 illustrates an example process for manufacturing trench capacitors in a substrate of an interposer, in accordance with various embodiments.
FIG. 9 illustrates multiple examples of laser-assisted etching of glass interconnects processes, in accordance with various embodiments.
FIG. 10 illustrates an example of a process for manufacturing electrically coupled trench capacitors, in accordance with various embodiments.
FIG. 11 schematically illustrates a computing device, in accordance with embodiments.

### DETAILED DESCRIPTION

Embodiments of the present disclosure may generally relate to systems, apparatus, techniques, and/or processes directed to creating electrically coupled trench capacitors within a substrate. In embodiments, the substrate, which may be an organic substrate or a glass substrate, may be part of an interposer. In embodiments, these trench capacitors may deliver a very high capacitance density that is physically close to one or more dies that are attached to the substrate. In embodiments, portions of an electrically coupled trench capacitor may include a thin film capacitor at a surface of the substrate, where the thin-film capacitor electrically couple a plurality of trench capacitors. In embodiments, the trench that makes up a trench capacitor extends from a first side of the substrate toward a second side of the substrate opposite the first side.

In embodiments, this trench capacitor configuration offers enhanced capacitance density as compared to planar capacitors. In addition, manufacturing methods for electrically connected trench capacitors may take advantage of available manufacturing processes for silicon substrates as well as glass substrates. In embodiments where glass substrates are used, atomic layer deposition (ALD) may be used to apply first and second conductive layers, as well as intermediate dielectric layers, within the trenches. Embodiments using glass substrates are able to tolerate higher temperatures that may be less well-tolerated with an organic or dielectric-based substrate. In addition, embodiments using glass substrates may enable trench creation and deposition techniques that produce high aspect ratio trenches within the glass.

In embodiments, where the electrically coupled trench capacitor is used for power delivery applications, a high-k dielectric material such as HfO₂, HfZrO₂ may be used. A thickness of the high-k dielectric material may be adjusted with nanometer precision, depending upon the density of the trenches and/or breakdown voltage requirements. In embodiments where the electrically coupled trench capacitor is used for radio frequency (RF) or input output (I/O) applications where a lower capacitance density may be desired, less expensive deposition materials and techniques may be used. These may include, but are not limited to, SiO₂, Si₃N₄ materials and plasma-enhanced chemical vapor deposition (PECVD) techniques for creating electrically coupled trench capacitors. In embodiments, the trench architecture allows for minimizing lateral sizes of capacitors while the same time using existing manufacturing methods for silicon and glass to ensure a high dimensional accuracy and stability for these capacitors with high-quality factors.

Legacy implementations for capacitors use discrete land side capacitors (LSC) or die side capacitors (DSC) for decoupling and for managing different voltage droops. In legacy embodiments, discrete capacitors may be placed within the core, or within build-up layers surrounding the core. In legacy implementations, capacitors may be part of the voltage regulator system to convert high DC to lower DC voltage. These legacy capacitors are individually placed and then attached to a substrate package, for example via a mass reflow process. Some implementations may use substrate package thin film capacitors that may be manufactured on active, however these are planar capacitors.

These legacy implementations have disadvantages. For example discrete capacitors cannot be placed close to a die. They may be placed either at the bottom of the substrate (LSC) in which case power has to go through the entire substrate to the die. For LSC that are placed on a package top and where power needs to flow laterally into a die, this creates a longer physical distance to the die than for LSCs. In addition, discrete capacitors have various parasitic elements that may have detrimental effects for package operation.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

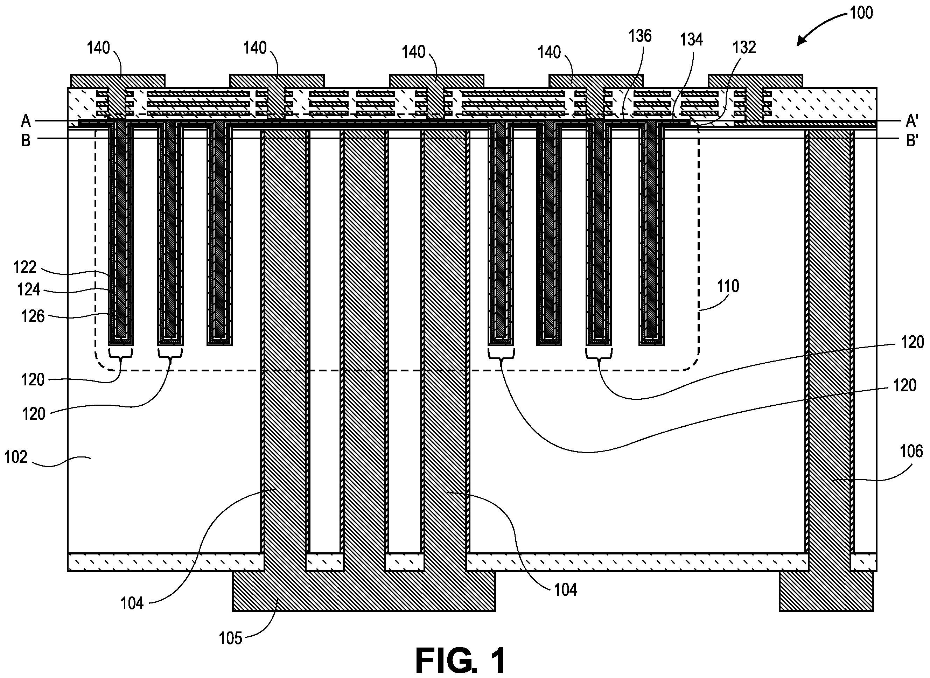

FIG. 1 illustrates a cross section side view of a substrate that includes electrically coupled trench capacitors, in accordance with various embodiments. Interposer 100 shows a substrate 102 that includes a plurality of vias 104, 106, that are filled with a conductive material such as copper. The vias 104, 106 extend from a first side of the substrate 102 to a second side of the substrate 102 opposite the first side and electrically couple the first side and the second side of the substrate 102. In embodiments, the vias 104 may conduct power through the substrate 102, and vias 106 may conduct RF or I/O signals through the substrate 102.

Coupled trench capacitor 110 is at least in part located within the substrate 102, and includes a plurality of trenches 120 that extend from a first side of the substrate 102 toward but not completely reaching the second side of the substrate 102. In some embodiments, the trenches 120 may extend completely through the substrate 102 to couple with a first voltage source at the second side and a second voltage source at the first side of the substrate 102.

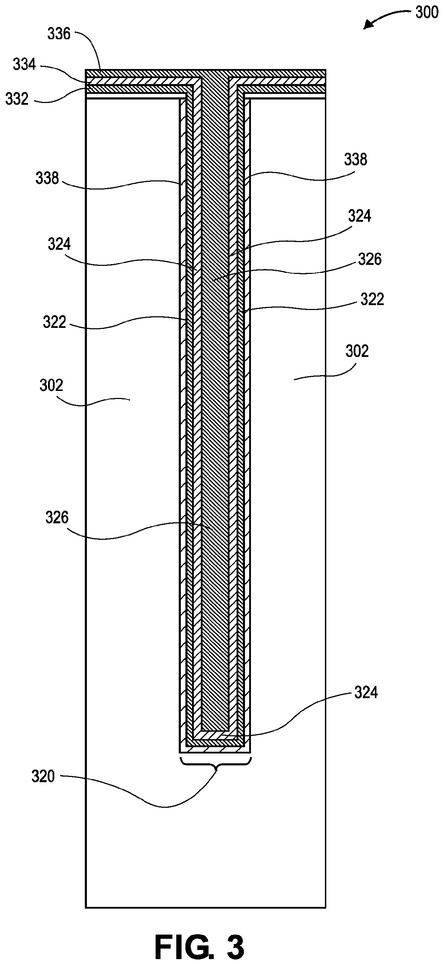

Trench capacitor 120 may include a first electrical conductor 122, a dielectric layer 124, and a second electrical conductor 126, as discussed in greater detail below with respect to FIG. 3. As shown with interposer 100, power may be supplied through vias 104 and coupled with a first conductive layer 132 that is electrically coupled with the first electrical conductor 122. A dielectric layer 134 may be placed on the first conductive layer 132, which electrically isolates the first conductive layer 132 from a second conductive layer 136. The second conductive layer 136 is electrically coupled with pads 140 that in turn may be subsequently physically and electrically coupled with a die (not shown). In embodiments, the pads 140 may be implemented as part of a first level interconnect (FLI). In embodiments, the vias 104 may be coupled with a mid-level interconnect (MLI) pad 105 at the second side of the substrate 102 at the bottom of the interposer 100.

In embodiments, the coupled trench capacitor 110 may be manufactured prior to the creation of the interposer 100 backend, for example as MLI 105. In embodiments, a trench capacitor 120 can have a high-k or ultra-high-k dielectric material and reach capacitance densities in the range of ~ 100 nF/mm2, with values that may reach or exceed 200nF/mm2. These values may depend on various factors that may include the use of high-k or ultra-high-k dielectric materials, thickness of the dielectric, and breakdown voltage requirement. In embodiments, a total capacitance that may be required by the application of the device may also dictate the thickness of the dielectric, the composition of the material, and a total area needed for the capacitor.

Thus, in embodiments, the coupled trench capacitor 110 may be used as a total substitution for a LSC, while the same time being placed in immediate proximity to a die (not shown) that may be connected to pads 140. In embodiments, the coupled trench capacitor 110 may be implemented on active or passive silicon or glass interposers, however, in embodiments, there may be more space or area available on passive interposers. In addition, embodiments that implement RF capacitors may enable complex front end modules that require many capacitors to have minimal size and achieve maximal system density.

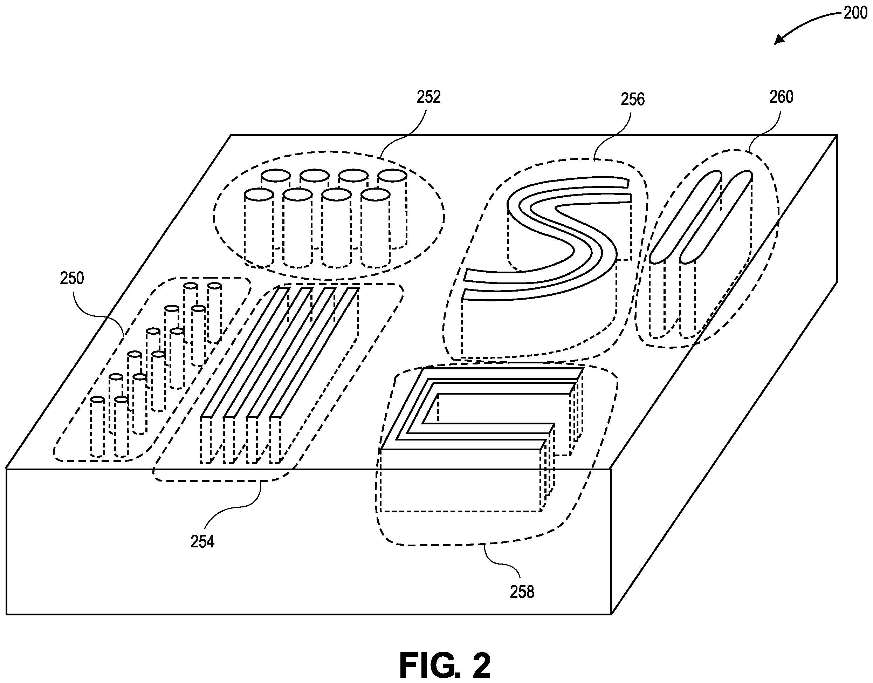

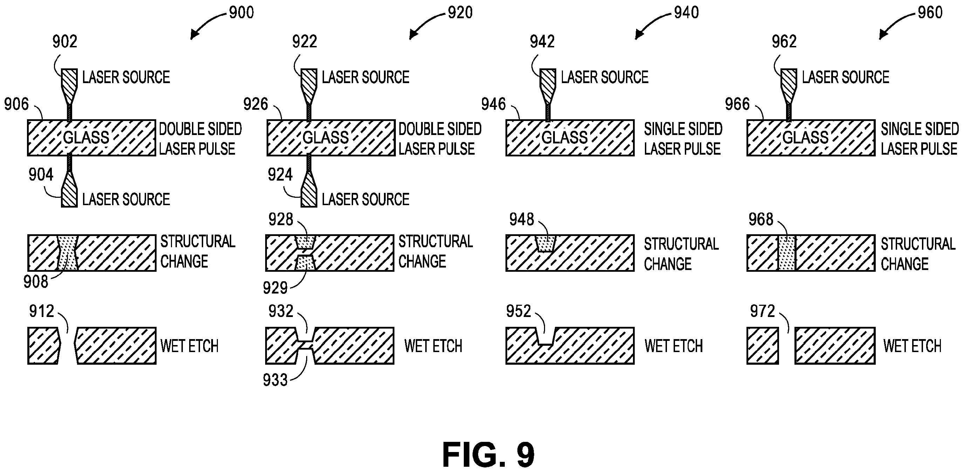

FIG. 2 illustrates a perspective view of a substrate with various trench etchings, in accordance with various embodiments. Substrate 200, which may be similar to substrate 102 of FIG. 1, shows only a few of the possible configurations for multiple architectures for trenches, such as trenches 120 of FIG. 1. In embodiments, the various architectures for trenches may be designed using techniques described below with respect to FIG. 9.

Trench example 250 may include circular vias, for example through glass vias (TGV) that are clustered together and have a defined pitch between the individual circular vias. Trench example 252 may include oval vias that may be clustered together again with a certain pitch between them, as well as a certain orientation for each of the respective vias. Trench example 254 shows a cluster of planes that are all substantially parallel, with a defined pitch between each of the planes. Trench example 256 shows curved planes that are substantially parallel. Trench example 258 shows two U-shaped trenches that are nested. Trench example 260 show two parallel planes with rounded ends, which may also be referred to as "pill shaped."

FIG. 3 illustrates a cross section side view of layers within a single trench, in accordance with various embodiments. Interposer portion 300, which may be similar to interposer 100 of FIG. 1, includes a substrate 302 and a trench 320 that may be similar to substrate 102 and trench 120 of FIG. 1. The trench 320 includes a first electrical conductor 322, a dielectric layer 324, and a second electrical conductor 326, which may be similar to first electrical conductor 122, dielectric layer 124, and second electrical conductor 126 of FIG. 1.

In embodiments, the first electrical conductor 322 may electrically couple with a first conductive layer 332, which may be similar to first conductive layer 132 of FIG. 1. A second electrical conductor 326 may electrically couple with a second conductive layer 336, which may be similar to second conductive layer 136 of FIG. 1. Dielectric layer 334, which may be similar to dielectric layer 134 of FIG. 1, together with dielectric layer 324 electrically isolates the first electrical conductor 322 and the second electrical conductor 326.

In embodiments, a barrier layer 338 may be placed between the substrate 302 and the first electrical conductor 322. In embodiments, the barrier layer 338 may include cobalt, tantalum, nitrogen, or ruthenium. A thickness and composition of the barrier layer 338 may be selected such that any metal within the first electrical conductor 322, which may include copper, does not defuse, or reduces the amount of diffusion of, metal into the substrate 302. During high temperatures resulting from the manufacture process and/or during operation, copper, for example, may diffuse into the glass or silicon substrate 302. For embodiments where a pitch between the trenches 320 is tight, for example less than 5 µm, a barrier layer 338 may be used to prevent diffusion and thus prevent degradation of the conductivity of the metal, or to prevent electrical shorts between a trench 320 and another structure within the substrate 302 due to diffused copper.

In embodiments, where the capacitor that includes trench 320 is used for power delivery, then the dielectric layer 324 and dielectric layer 334 may use high-k dielectric class materials such as Ti02, HfO₂, HfZrO₂, TaO₂Zr, or similar. In embodiments, an ultra high-k dielectric class material may also be used that includes BaTiO₃, BaSrTiO₃, or similar material. For first electrical conductor 322 or second electrical conductor 326, copper may be used, if there is good band alignment. Other conductive materials that may be used include Ir, Pt, Pd, RuO₂, Ir02, Al, Ag, Ti, and/or Mo. A choice of these materials may depend upon the dielectric material used.

In embodiments where the capacitor that includes the trench 320 is used for RF or I/O delivery, then low-k, low-loss materials may be used for dielectric layer 324 and dielectric layer 334, such as Si02, Si₃N₄, and Al₂O₃.

In embodiments, an additional current leakage barrier (not shown) may be placed between the dielectric layers and electrical conductors, for example between dielectric layers 324, 334 and electrical conductors 322, 326. This current leakage barrier may be on the order of 10 to 20 nm. Depending upon the properties of the dielectric, the current leakage barrier may include radium, platinum, palladium and/or RuO₂. The current leakage barrier may be particularly helpful at higher operating voltages, given certain dielectrics such as Ti02 that will allow a high rate of electrical leakage without a current leakage barrier. Capacitors with a low leakage are able to operate at a higher voltage.

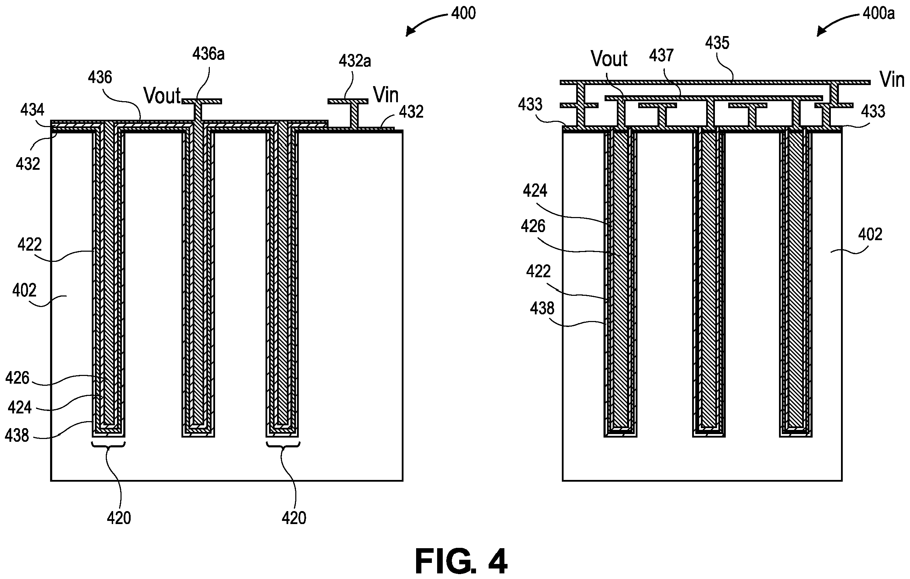

FIG. 4 illustrates cross section side views of electrical coupling structures used with electrically coupled trench capacitors, in accordance with various embodiments. Interposer portion 400 and 400a, which may be similar to interposer 100 of FIG. 1, show examples of coupled trench capacitors where both electrical contacts are on one side of the substrate 402.

Interposer portion 400 includes a substrate 402 and trench 420 that may be similar to substrate 302 and trench 320 of FIG. 3. The trench 420 includes a first electrical conductor 422, a dielectric layer 424, and a second electrical conductor 426, which may be similar to first electrical conductor 322, dielectric layer 324, and second electrical conductor 326 of FIG. 3. A barrier layer 438, which may be similar to barrier layer 338 of FIG. 3, may be positioned between the substrate 402 and the first electrical conductor 422.

In embodiments, the first electrical conductor 422 may electrically couple with a first conductive layer 432, which may be similar to first conductive layer 332 of FIG. 3. A second electrical conductor 426 may electrically couple with a second conductive layer 436, which may be similar to second conductive layer 336 of FIG. 3. Dielectric layer 434, which may be similar to dielectric layer 334 of FIG. 3, together with dielectric layer 424 electrically isolates the first electrical conductor 422 and the second electrical conductor 426. A first electrical connector 432a that is electrically coupled with first conductive layer 432 may exist as a pad on top of a buildup layer on top of the substrate 402. A second electrical connector 436a is electrically coupled with the second conductive layer 436 and may exist as a pad on top of the buildup layer on top of the substrate 402. The electrical connectors 432a, 436a may be copper pads that may be subsequently hybrid bonded to a die (not shown), or may have solder placed on them for subsequent bonding to a die (not shown).

Interposer portion 400a may be similar to interposer portion 400, however the electrical coupling of the first electrical conductor 422 goes through a routing layer 433 and up to a first plane 437 within the buildup portion on a side of the substrate 402. The electrical coupling of the second electrical conductor 426 goes up through a second plane 437. In this way, the two separate routing planes 435, 437 are electrically isolated from each other and may be at different electric potentials.

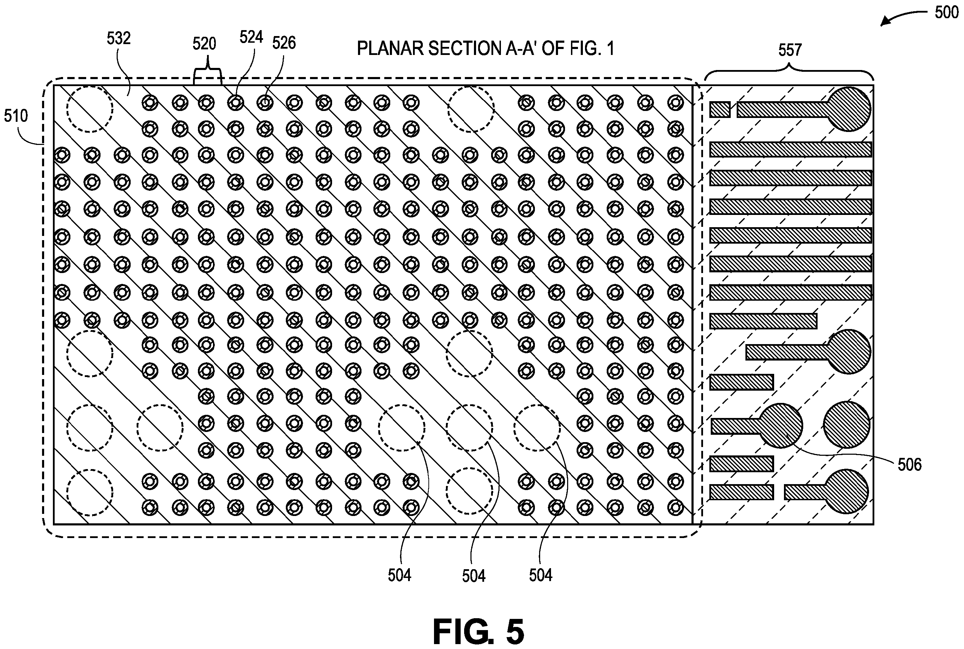

FIG. 5 illustrates a cross-section top view of a substrate that includes trench capacitors coupled with a conductive layer, in accordance with various embodiments. Interposer 500 shows a cross-section top down view at the location A-A' of FIG. 1, through the first conductive layer 132. First conductive layer 532 may be similar to first conductive layer 132 FIG. 1. Conductive layer 532 is shown here as a metal layer that includes copper. The dielectric 524, which may be similar to dielectric layer 124 of FIG. 1, surrounds and electrically isolates the second electrical conductor 526 from the first conductive layer 532. Vias 504, which may be similar to vias 104 of FIG. 1, provide power to the first conductive layer 532. As shown, I/O signals may come through via 506, which may be similar to via 106 of FIG. 1. Area 557 includes one or more structures, for example traces, that are not directly associated with the coupled trench capacitor 510.

In other embodiments (not shown) the conductive layer 532 may be traces that electrically couple one or more trench capacitors 520, which may be similar to trench capacitor 120 of FIG. 1, in various groups or patterns. These groups or patterns may be chosen based upon the required capacitance for the coupled trench capacitor 510.

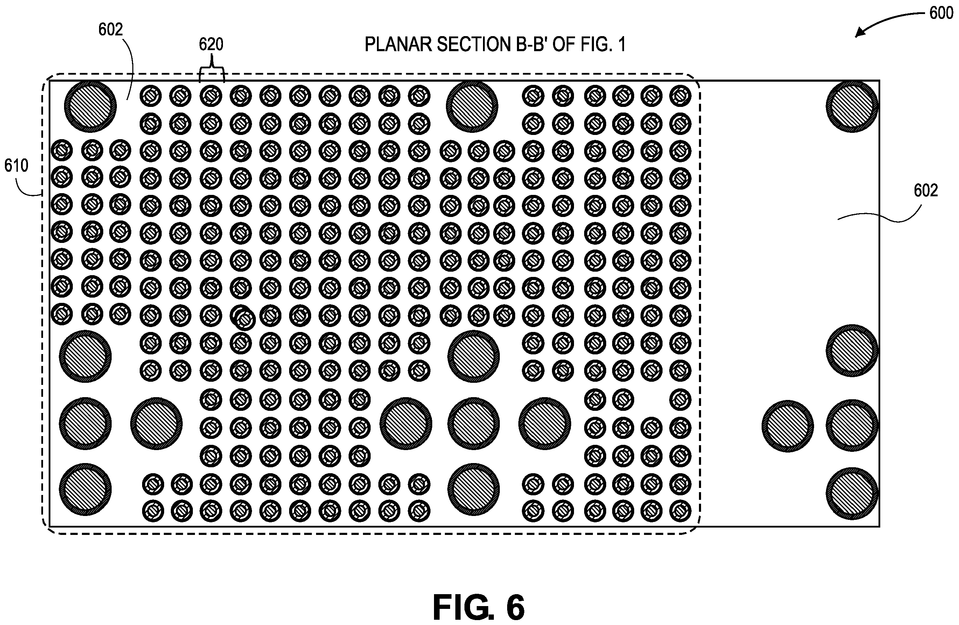

FIG. 6 illustrates a cross-section top view of a substrate that includes electrically coupled trench capacitors, in accordance with various embodiments. Interposer 600 shows a cross-section top down view at the location B-B' of FIG. 1, below location A-A'. At this cross-section, the substrate 602, which may be similar to substrate 102 of FIG. 1, surrounds a plurality of trench capacitors 620 that make up coupled trench capacitor 610, which may be similar to coupled trench capacitor 110 of FIG. 1. In this embodiment, the individual trench capacitor 620 are circular vias. However, in other embodiments, individual trench capacitor 620 may take some other shape, such as those shapes shown with respect to FIG. 2.

Embodiments with respect to FIGs. 1-6, may differ based upon the use of the electrically coupled trench capacitors. For example in the case of power applications, an electrically coupled trench capacitor may be significantly larger than a single capacitor, and include many trenches. In embodiments, several such electrically coupled trench capacitors may be used, for example, one each per functional area of a die that may be coupled with an interposer. In embodiments, these functional areas of the die may include cores, uncores, and graphics.

In embodiments, the trenches, such as trench 120 of FIG. 1, may not extend directly through the thickness of the substrate, such as substrate 102 of FIG. 1. In some embodiments, a depth of the trenches may not be more than halfway into the thickness of the substrate. In embodiments, an overall capacitance of an electrically coupled trench capacitor may be adjusted by varying the depth of the trenches or the thickness of the trenches, as well as the thickness and composition of any dielectric or electrical conductor within the trench capacitors or electrically coupling the trench capacitors to form and electrically couple trench capacitors.

**Table 1: Capacitance densities for different dielectric materials and thicknesses.**

| Dielectric | k-value | thickness [nm] | trench diameter [um] | trench pitch [um] | Aspect ratio | capacitance for single trench and planar areas connecting to othertrenches [nF] | capacitance/area assuming 50% area used by TSV/TGV [nF/mm^2] |
|---|---|---|---|---|---|---|---|
| HfZrO2 | 24 | 10 | 2 | 4 | 10 | 0.002925365 | 91.42 |
| HfZrO2 | 24 | 20 | 2 | 4 | 10 | 0.001462682 | 45.71 |
| TiO2 | 72 - 96 | 10 | 2 | 4 | 10 | 0.0088 - 0.0118 | 275 - 368.8 |
| TiO2 | 72 - 96 | 20 | 2 | 4 | 10 | 0.0044 - 0.0059 | 137.5 - 184.4 |
| TiO2 | 72 - 96 | 30 | 2 | 4 | 10 | 0.0029 - 0.0039 | 90.6 - 121.9 |
| BaSrTiO3 | 1000 | 400 | 2 | 4 | 10 | 0.003047255 | 95.23 |

Table 1 illustrates various capacitance densities of various embodiments based on various parameters. Note that the capacitance density does not change with changing geometric assumption for the various trenches, as long as the aspect ratio (AR-trench diameter to trench height) stays constant. For example, if the diameter jumps from 2um in the table to 10um, but the pitch increases by the same value e.g. from 4um to 20um at an AR of 10, the same capacitance densities may be observed.

In embodiments, for a dielectric thickness for materials such as HfO₂, ZrO₂, HfZrO₂, Ti02, the breakdown voltages are in the 1-3 MV/cm range. A 10nm dielectric can support ~ 2V breakdown, while 20nm and 30nm dielectrics can support voltages in the range of 4V and 6V respectively. Table 1 also illustrates that BaSrTiO₃, and similar ultra-high-k materials, do not have a significant capacitance density advantage. However, at 400nm dielectric thickness, the breakdown voltage can be much higher than for Ti02. In addition, k-values higher than 1000 are possible, thus higher densities are possible with these materials. In embodiments, glass processing allows for much higher deposition temperatures and processes such as ALD or Epitaxy that may allow creation of the necessary crystallinity for the ultra-high-k dielectric materials.

Finally, values obtained in the table assume that 50% of the interposer area is used by TSVs that are not associated with power and cannot be used for capacitors. These calculations also illustrate electrically coupled trench capacitors may be used in passive interposers, where a maximal amount of interposer area can be used for capacitors. In the case of active interposers, as long as most of the active circuitry is outside of the areas of the dies assembled on the interposer that need capacitors, high densities can be achieved. The calculations in Table 1 are valid for a plain square trench pattern. For other embodiments of trench patterns, such as a hex-pack arrangement, the capacitance densities would be somewhat higher.

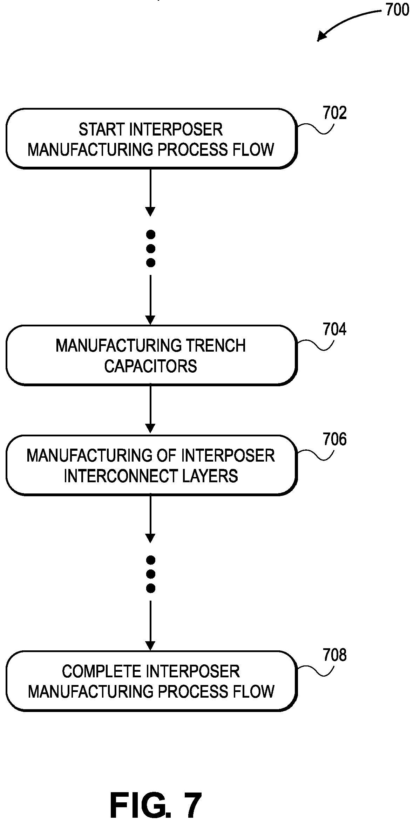

FIG. 7 illustrates an example process for manufacturing an interposer, in accordance with various embodiments. Process 700 includes stages in the manufacturing process for creating an interposer, and may be performed using processes, techniques, systems, and/or apparatus described herein and in particular with respect to FIGs. 1-6.

At block 702, the interposer manufacturing process flow may start.

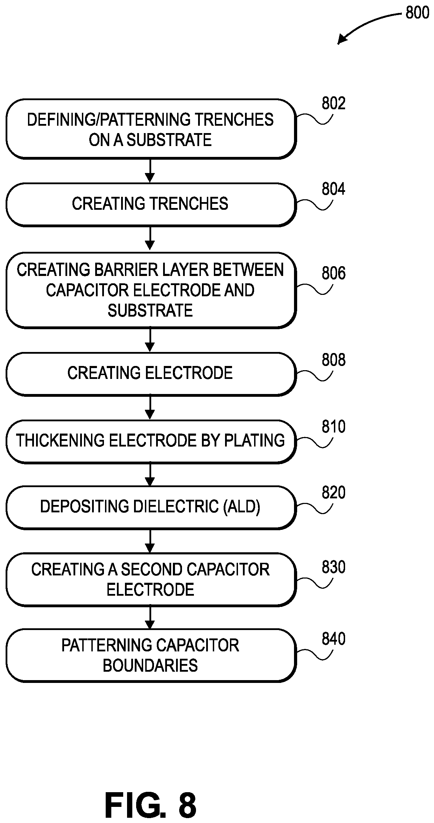

At block 704, the process may further include manufacturing one or more trench capacitors. In embodiments, the one or more trench capacitors, such as trench capacitor 120 of FIG. 1, may be formed within a substrate, such as substrate 102 of FIG. 1. In embodiments, the one or more trench capacitors may electrically coupled using techniques described above respect to FIGs. 1-6. Embodiments of sub processes related to block 704 are described below with respect to FIG. 8.

At block 706, the process may further include manufacturing interposer interconnect layers. In embodiments, this may include attaching MLI pads, such as MLI pad 105 FIG. 1, or attaching FLI pads such as pads 140 of FIG. 1.

Note that between block 702 and 704, and between block 706 and 708 there may be additional steps (not shown) with respect to manufacturing an interposer that includes electrically coupled trench capacitors.

FIG. 8 illustrates an example process for manufacturing trench capacitors in a substrate of an interposer, in accordance with various embodiments. Process 800 includes stages in the manufacturing process for creating and electrically coupled trench capacitor, and may be performed using processes, techniques, systems, and/or apparatus described herein and in particular with respect to FIGs. 1-7.

At block 802, the process may include defining or patterning trenches on a substrate. In embodiments, the substrate may be similar to substrate 102 of FIG. 1. In embodiments, this may be performed using lithography techniques.

At block 804, the process may further include creating trenches. In embodiments, trenches may be similar to trenches 120 of FIG. 1. In embodiments, the trenches may be created within glass substrates using techniques described in FIG. 9. In other embodiments, a reactive ion etch (RIE) technique may be used.

At block 806, the process may further include creating a barrier layer between the capacitor electrode and the substrate. In embodiments, this barrier layer may be similar to barrier layer 338 of FIG. 3. In embodiments, this barrier layer may include TaN or Si₃N₄.

At block 808, the process may further include creating an electrode. In embodiments, the electrode may be similar to first electrical conductor 322 of FIG. 3, and may be disposed upon the barrier layer 338. In embodiments, the electrode may be deposited using an ALD process. The electrode may include one or more of copper, titanium, aluminum, RuO₂, iridium, platinum, and/or palladium.

At block 810, the process may further include thickening the electrode to provide higher conductivity. In embodiments, the thickening may be performed using a plating process.

At block 820, the process may further include depositing a dielectric. In embodiments, the dielectric may be similar to dielectric layer 324 of FIG. 3. In embodiments, the dielectric may be deposited using ALD techniques.

At block 830, the process may further include creating a second capacitor electrode. In embodiments, the second capacitor electrode may be similar to second electrical conductor 326 of FIG. 3. In embodiments, this process may use ALD techniques and/or plating techniques. For example, ALD techniques may be used to apply Ru, RuO₂, platinum, palladium, and/or iridium, with copper plated on top.

At block 840, the process may further include patterning capacitor boundaries. In embodiments, these boundaries are used to form the electrically coupled trench capacitor 110 of FIG. 1. In embodiments, these boundaries may be formed by applying a first conductive layer and/or a second conductive layer, such as first conductive layer 132 and second conductive layer 136 of FIG. 1. In embodiments, the boundaries may be formed using one or more steps of lithography in conjunction with RIE techniques to apply electrodes and/or dielectric.

FIG. 9 illustrates multiple examples of laser-assisted etching of glass interconnects processes, in accordance with various embodiments. FIG. 9 illustrates multiple examples of laser-assisted etching of glass interconnects processes (which may be referred to as "LEGIT" herein), in accordance with embodiments. One use of the LEGIT technique is to provide an alternative substrate core material to the legacy copper clad laminate (CCL) core used in semiconductor packages used to implement products such as servers, graphics, clients, 5G, and the like. By using laser-assisted etching, crack free, high density via drills, hollow shapes may be formed into a glass substrate. In embodiments, different process parameters may be adjusted to achieve drills of various shapes and depths, thus opening the door for innovative devices, architectures, processes, and designs in glass. Embodiments, such as the bridge discussed herein, may also take advantage of these techniques.

Diagram 900 shows a high level process flow for a through via and blind via (or trench) in a microelectronic package substrate (e.g. glass) using LEGIT to create a through via or a blind via. A resulting volume/shape of glass with laser-induced morphology change that can then be selectively etched to create a trench, a through hole or a void that can be filled with conductive material. A through via 912 is created by laser pulses from two laser sources 902, 904 on opposite sides of a glass wafer 906. As used herein, a through drill and a through via refers to when the drill or the via starts on one side of the glass/substrate and ends on the other side. A blind drill and a blind via refers to when the drill or the via starts on the surface of the substrate and stops half way inside the substrate. In embodiments, the laser pulses from the two laser sources 902, 904 are applied perpendicularly to the glass wafer 906 to induce a morphological change 908, which may also be referred to as a structural change, in the glass that encounters the laser pulses. This morphological change 908 includes changes in the molecular structure of the glass to make it easier to etch out (remove a portion of the glass). In embodiments, a wet etch process may be used.

Diagram 920 shows a high level process flow for a double blind shape. A double blind shape 932, 933 may be created by laser pulses from two laser sources 922, 924, which may be similar to laser sources 902, 904, that are on opposite sides of the glass wafer 926, which may be similar to glass wafer 906. In this example, adjustments may be made in the laser pulse energy and/or the laser pulse exposure time from the two laser sources 922, 924. As a result, morphological changes 928, 929 in the glass 926 may result, with these changes making it easier to etch out portions of the glass. In embodiments, a wet etch process may be used.

Diagram 940 shows a high level process flow for a single-blind shape, which may also be referred to as a trench. In this example, a single laser source 942 delivers a laser pulse to the glass wafer 946 to create a morphological change 948 in the glass 946. As described above, these morphological changes make it easier to etch out a portion of the glass 952. In embodiments, a wet etch process may be used.

Diagram 960 shows a high level process flow for a through via shape. In this example, a single laser source 962 applies a laser pulse to the glass 966 to create a morphological change 968 in the glass 966, with the change making it easier to etch out a portion of the glass 972. As shown here, the laser pulse energy and/or laser pulse exposure time from the laser source 962 has been adjusted to create an etched out portion 972 that extends entirely through the glass 966.

With respect to FIG. 9, although embodiments show laser sources 902, 904, 922, 924, 942, 962 as perpendicular to a surface of the glass 906, 926, 946, 966, in embodiments, the laser sources may be positioned at an angle to the surface of the glass, with pulse energy and/or pulse exposure time variations in order to cause a diagonal via or a trench, or to shape the via, such as 912, 972, for example to make it cylindrical, tapered, or include some other feature. In addition, varying the glass type may also cause different features within a via or a trench as the etching of glass is strongly dependent on the chemical composition of the glass.

In embodiments using the process described with respect to FIG. 9, through hole vias 912, 972 may be created that are less than 10 µm in diameter, and may have an aspect ratio of 40:1 to 50:1. As a result, a far higher density of vias may be placed within the glass and be placed closer to each other at a fine pitch. In embodiments, this pitch may be 50 µm or less. After creating the vias or trenches, a metallization process may be applied in order to create a conductive pathway through the vias or trenches, for example a plated through hole (PTH). Using these techniques, finer pitch vias will result in better signaling, allowing more I/O signals to be put through the glass wafer and to other coupled components such as a substrate.

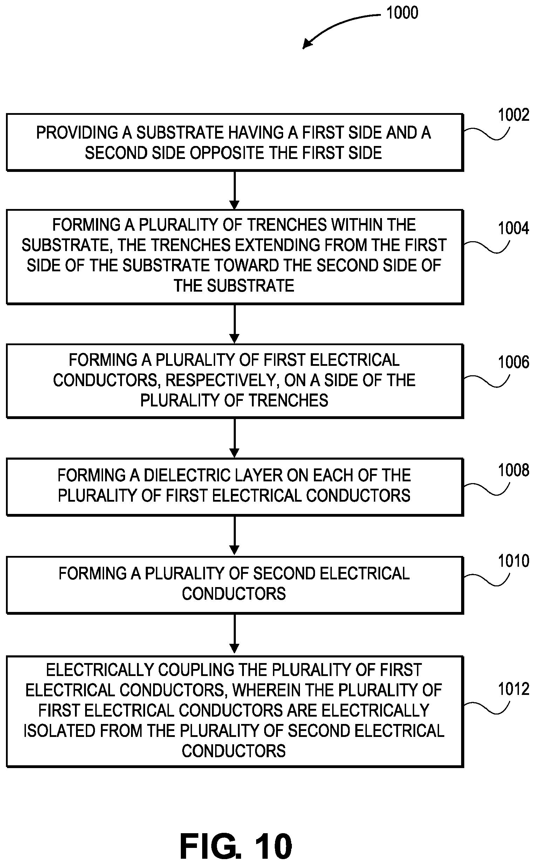

FIG. 10 illustrates an example of a process for manufacturing electrically coupled trench capacitors, in accordance with various embodiments. Process 1000 may be manufactured using the techniques, processes, systems, and/or apparatuses described herein and particularly with respect to FIGs. 1-9.

At block 1002, the process may include providing a substrate having a first side and a second side opposite the first side.

At block 1004, the process may further include forming a plurality of trenches within the substrate, the trenches extending from the first side of the substrate toward the second side of the substrate.

At block 1006, the process may further include forming a plurality of first electrical conductors, respectively, on a side of the plurality of trenches.

At block 1008, the process may further include forming a dielectric layer on each of the plurality of first electrical conductors.

At block 1010, the process may further include forming a plurality of second electrical conductors.

At block 1012, the process may further include electrically coupling the plurality of first electrical conductors, wherein the plurality of first electrical conductors are electrically isolated from the plurality of second electrical conductors.

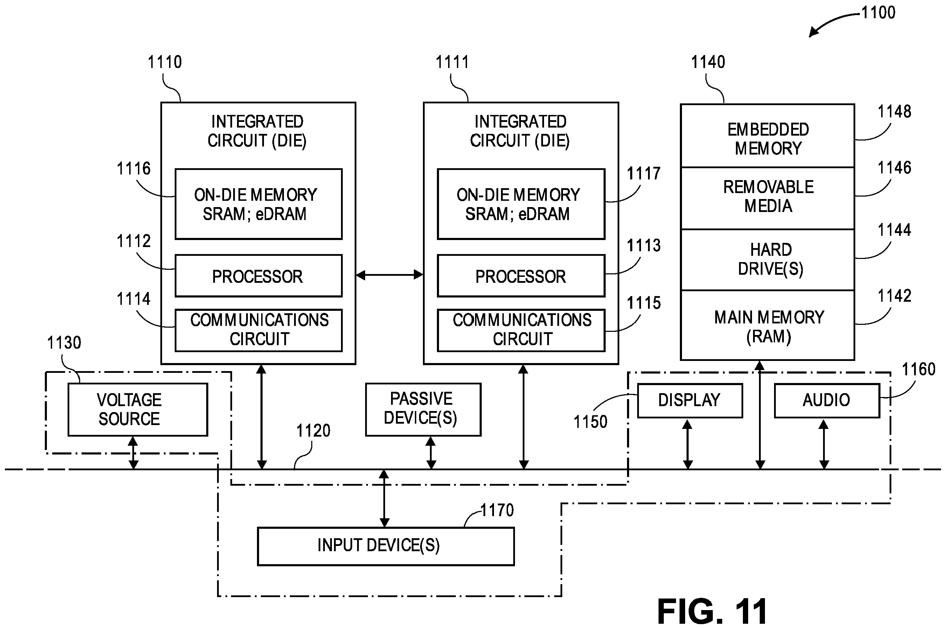

FIG. 11 is a schematic of a computer system 1100, in accordance with an embodiment of the present invention. The computer system 1100 (also referred to as the electronic system 1100) as depicted can embody electrically coupled trench capacitors within a substrate, according to any of the several disclosed embodiments and their equivalents as set forth in this disclosure. The computer system 1100 may be a mobile device such as a netbook computer. The computer system 1100 may be a mobile device such as a wireless smart phone. The computer system 1100 may be a desktop computer. The computer system 1100 may be a hand-held reader. The computer system 1100 may be a server system. The computer system 1100 may be a supercomputer or high-performance computing system.

In an embodiment, the electronic system 1100 is a computer system that includes a system bus 1120 to electrically couple the various components of the electronic system 1100. The system bus 1120 is a single bus or any combination of busses according to various embodiments. The electronic system 1100 includes a voltage source 1130 that provides power to the integrated circuit 1110. In some embodiments, the voltage source 1130 supplies current to the integrated circuit 1110 through the system bus 1120.

The integrated circuit 1110 is electrically coupled to the system bus 1120 and includes any circuit, or combination of circuits according to an embodiment. In an embodiment, the integrated circuit 1110 includes a processor 1112 that can be of any type. As used herein, the processor 1112 may mean any type of circuit such as, but not limited to, a microprocessor, a microcontroller, a graphics processor, a digital signal processor, or another processor. In an embodiment, the processor 1112 includes, or is coupled with, electrically coupled trench capacitors within a substrate, as disclosed herein. In an embodiment, SRAM embodiments are found in memory caches of the processor. Other types of circuits that can be included in the integrated circuit 1110 are a custom circuit or an application-specific integrated circuit (ASIC), such as a communications circuit 1114 for use in wireless devices such as cellular telephones, smart phones, pagers, portable computers, two-way radios, and similar electronic systems, or a communications circuit for servers. In an embodiment, the integrated circuit 1110 includes on-die memory 1116 such as static random-access memory (SRAM). In an embodiment, the integrated circuit 1110 includes embedded on-die memory 1116 such as embedded dynamic random-access memory (eDRAM).

In an embodiment, the integrated circuit 1110 is complemented with a subsequent integrated circuit 1111. Useful embodiments include a dual processor 1113 and a dual communications circuit 1115 and dual on-die memory 1117 such as SRAM. In an embodiment, the dual integrated circuit 1110 includes embedded on-die memory 1117 such as eDRAM

In an embodiment, the electronic system 1100 also includes an external memory 1140 that in turn may include one or more memory elements suitable to the particular application, such as a main memory 1142 in the form of RAM, one or more hard drives 1144, and/or one or more drives that handle removable media 1146, such as diskettes, compact disks (CDs), digital variable disks (DVDs), flash memory drives, and other removable media known in the art. The external memory 1140 may also be embedded memory 1148 such as the first die in a die stack, according to an embodiment.

In an embodiment, the electronic system 1100 also includes a display device 1150, an audio output 1160. In an embodiment, the electronic system 1100 includes an input device such as a controller 1170 that may be a keyboard, mouse, trackball, game controller, microphone, voice-recognition device, or any other input device that inputs information into the electronic system 1100. In an embodiment, an input device 1170 is a camera. In an embodiment, an input device 1170 is a digital sound recorder. In an embodiment, an input device 1170 is a camera and a digital sound recorder.

As shown herein, the integrated circuit 1110 can be implemented in a number of different embodiments, including a package substrate having electrically coupled trench capacitors within a substrate, according to any of the several disclosed embodiments and their equivalents, an electronic system, a computer system, one or more methods of fabricating an integrated circuit, and one or more methods of fabricating an electronic assembly that includes a package substrate having electrically coupled trench capacitors within a substrate, according to any of the several disclosed embodiments as set forth herein in the various embodiments and their art-recognized equivalents. The elements, materials, geometries, dimensions, and sequence of operations can all be varied to suit particular I/O coupling requirements including array contact count, array contact configuration for a microelectronic die embedded in a processor mounting substrate according to any of the several disclosed package substrates having electrically coupled trench capacitors within a substrate embodiments and their equivalents. A foundation substrate may be included, as represented by the dashed line of FIG. 11. Passive devices may also be included, as is also depicted in FIG. 11.

### EXAMPLES

The following paragraphs describe examples of various embodiments.

Example 1 is a capacitor comprising: a substrate having a first side and a second side opposite the first side; a plurality of trenches within the substrate, the trenches extending from the first side of the substrate toward the second side of the substrate; a plurality of first electrical conductors, respectively, on a side of the plurality of trenches; a plurality of dielectric layers, respectively, on the plurality of first electrical conductors; a plurality of second electrical conductors, respectively, on the plurality of dielectric layers, wherein the plurality of first electrical conductors are electrically isolated from the plurality of second electrical conductors; and wherein the plurality of first electrical conductors are electrically coupled with each other, and wherein the plurality of second electrical conductors are electrically coupled with each other.

Example 2 may include the capacitor of example 1, or of any other example or embodiment described herein, wherein the substrate includes glass.

Example 3 may include the capacitor of example 1, or of any other example or embodiment described herein, wherein at least one of the plurality of trenches has a cross section at a plane parallel to the first side of the substrate that includes a selected one or more of: a circle, an ellipse, a square, a rectangle, or a pill shape.

Example 4 may include the capacitor of example 1, or of any other example or embodiment described herein, wherein a width of one of the plurality of trenches ranges from 1 - 10 µm, and wherein a depth of one of the plurality of trenches ranges from 1 - 10 µm.

Example 5 may include the capacitor of example 1, or of any other example or embodiment described herein, further including a conductive layer on the first side of the substrate, wherein the conductive layer electrically couples the plurality of first electrical conductors.

Example 6 may include the capacitor of example 5, or of any other example or embodiment described herein, wherein the conductive layer is a first conductive layer, and further comprising: an insulating layer on top of the first conductive layer; an insulating layer on top of the first conductive layer; a second conductive layer on top of the insulating layer, wherein the insulating layer electrically isolates the first conductive layer and the second conductive layer; and wherein the second conductive layer electrically couples the plurality of second electrical conductors

Example 7 may include the capacitor of example 6, or of any other example or embodiment described herein, wherein the insulating layer includes a dielectric material.

Example 8 may include the capacitor of example 5, or of any other example or embodiment described herein, wherein the conductive layer is a first conductive layer, and further comprising a second conductive layer on the second side of the substrate, wherein the second conductive layer electrically couples the plurality of second electrical conductors.

Example 9 may include the capacitor of example 8, or of any other example or embodiment described herein, wherein the electrical conductors include copper.

Example 10 may include the capacitor of example 1, or of any other example or embodiment described herein, further comprising a plurality of barrier layers within the plurality of trenches, the plurality of barrier layers, respectively, between the substrate and the plurality of first electrical conductors.

Example 11 may include the capacitor of example of 10, or of any other example or embodiment described herein, wherein the barrier layer includes a selected one or more of: cobalt, tantalum, nitrogen, or ruthenium.

Example 12 may include the capacitor of example 1, or of any other example or embodiment described herein, further comprising: a first via and a second via within the substrate, the first via and the second via extending from the first side of the substrate to the second side of the substrate; a conductive material within the first via and the second via to electrically couple the first side of the substrate to the second side of the substrate; and wherein the conductive material in the first via is electrically coupled with the plurality of first electrical conductors and wherein the conductive material in the second via is electrically coupled with the plurality of second electrical conductors.

Example 13 may include the capacitor of example 12, or of any other example or embodiment described herein, wherein the first via and the second via are coupled with Vdd or Vss.

Example 14 may include the capacitor of example 1, or of any other example or embodiment described herein, further comprising: an electrical pad on the first side of the glass substrate; and a die electrically coupled to the first side of the glass substrate, wherein the electrical pad is electrically coupled with the die and electrically coupled with a selected one of: the plurality of first electrical conductors or the plurality of second electrical conductors.

Example 15 may include a method comprising: providing a substrate having a first side and a second side opposite the first side; forming a plurality of trenches within the substrate, the trenches extending from the first side of the substrate toward the second side of the substrate; forming a plurality of first electrical conductors, respectively, on a side of the plurality of trenches; forming a dielectric layer on each of the plurality of first electrical conductors; forming a plurality of second electrical conductors; and electrically coupling the plurality of first electrical conductors, wherein the plurality of first electrical conductors are electrically isolated from the plurality of second electrical conductors.

Example 16 may include the method of example 15, or of any other example or embodiment described herein electrically coupling the plurality of second electrical conductors.

Example 17 may include the method of example 15, or of any other example or embodiment described herein, wherein the substrate is a selected one or more of: glass or silicon; and wherein at least one of the plurality of trenches has a cross section at a plane parallel to the first side of the substrate that includes a selected one or more of: a circle, an ellipse, a square, a rectangle, or a pill shape.

Example 18 may include the method of example 15, or of any other example or embodiment described herein, wherein prior to forming the plurality of first electrical conductors, the method further comprising forming a plurality of barrier layers, respectively, within the plurality of trenches.

Example 19 may include the method of example 18, or of any other example or embodiment described herein, wherein at least one of the plurality of the barrier layers includes a selected one or more of: cobalt, tantalum, nitrogen, or ruthenium.

Example 20 may include the method of example 15, or of any other example or embodiment described herein, wherein a first electrical conductor or a second electrical conductor includes one or more of: copper, titanium, aluminum, ruthenium, oxygen, iridium, platinum, and/or palladium.

Example 21 may include the method of example 15, or of any other example or embodiment described herein wherein forming a plurality of first electrical conductors or forming a plurality of second electrical conductors further comprises depositing a conductive metal using atomic layer deposition (ALD).

Example 22 may include a package comprising: one or more dies; an interposer electrically and physically coupled with the one or more dies, the interposer comprising: a substrate having a first side and a second side opposite the first side; a plurality of trenches within the substrate, the trenches extending from the first side of the substrate toward the second side of the substrate; a plurality of first electrical conductors, respectively, on a side of the plurality of trenches; a plurality of dielectric layers, respectively, on the plurality of first electrical conductors; a plurality of second electrical conductors, respectively, on the plurality of dielectric layers, wherein the plurality of first electrical conductors are electrically isolated from the plurality of second electrical conductors, wherein the plurality of first electrical conductors are electrically coupled with each other, and wherein the plurality of second electrical conductors are electrically coupled with each other; a first set of one or more electrically conductive pads electrically coupled with the plurality of first electrical conductors; and a second set of one or more electrically conductive pads electrically coupled with the plurality of second electrical conductors; and wherein the first set of one or more electrically conductive pads and the second set of the one or more electrically conductive pads are electrically coupled with the one or more dies.

Example 23 may include the package of example 22, or of any other example or embodiment described herein, wherein the first set of one or more electrically conductive pads are at the first side of the substrate or the second set of one or more electrically conductive pads are at the second side of the substrate.

Example 24 may include the package of example 22, or of any other example or embodiment described herein, wherein at least one of the plurality of trenches has a cross section at a plane parallel to the first side of the substrate that includes a selected one or more of: a circle, an ellipse, a square, a rectangle, or a pill shape.

Example 25 may include the package of example 22, or of any other example or embodiment described herein, wherein the substrate includes a selected one of: glass or silicon.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize. These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

## Claims

1. A capacitor comprising:
a substrate having a first side and a second side opposite the first side;
a plurality of trenches within the substrate, the trenches extending from the first side of the substrate toward the second side of the substrate;
a plurality of first electrical conductors, respectively, on a side of the plurality of trenches;
a plurality of dielectric layers, respectively, on the plurality of first electrical conductors;
a plurality of second electrical conductors, respectively, on the plurality of dielectric layers, wherein the plurality of first electrical conductors are electrically isolated from the plurality of second electrical conductors; and
wherein the plurality of first electrical conductors are electrically coupled with each other, and wherein the plurality of second electrical conductors are electrically coupled with each other.

2. The capacitor of claim 1, wherein the substrate includes glass.

3. The capacitor of claim 1, wherein at least one of the plurality of trenches has a cross section at a plane parallel to the first side of the substrate that includes a selected one or more of: a circle, an ellipse, a square, a rectangle, or a pill shape.

4. The capacitor of claim 1, wherein a width of one of the plurality of trenches ranges from 1 - 10 µm, and wherein a depth of one of the plurality of trenches ranges from 1 - 10 µm.

5. The capacitor of claim 1, further including a conductive layer on the first side of the substrate, wherein the conductive layer electrically couples the plurality of first electrical conductors.

6. The capacitor of claim 5, wherein the conductive layer is a first conductive layer, and further comprising:
an insulating layer on top of the first conductive layer;
a second conductive layer on top of the insulating layer, wherein the insulating layer electrically isolates the first conductive layer and the second conductive layer; and
wherein the second conductive layer electrically couples the plurality of second electrical conductors.

7. The capacitor of claim 6, wherein the insulating layer includes a dielectric material.

8. The capacitor of claim 5, wherein the conductive layer is a first conductive layer, and further comprising a second conductive layer on the second side of the substrate, wherein the second conductive layer electrically couples the plurality of second electrical conductors.

9. The capacitor of claim 8, wherein the electrical conductors include copper.

10. The capacitor of claim 1, further comprising a plurality of barrier layers within the plurality of trenches, the plurality of barrier layers, respectively, between the substrate and the plurality of first electrical conductors.

11. The capacitor of claim of 10, wherein the barrier layer includes a selected one or more of: cobalt, tantalum, nitrogen, or ruthenium.

12. A method comprising:
providing a substrate having a first side and a second side opposite the first side;
forming a plurality of trenches within the substrate, the trenches extending from the first side of the substrate toward the second side of the substrate;
forming a plurality of first electrical conductors, respectively, on a side of the plurality of trenches;
forming a dielectric layer on each of the plurality of first electrical conductors;
forming a plurality of second electrical conductors; and
electrically coupling the plurality of first electrical conductors, wherein the plurality of first electrical conductors are electrically isolated from the plurality of second electrical conductors.

13. The method of claim 12, electrically coupling the plurality of second electrical conductors.

14. The method of claim 12, wherein the substrate is a selected one or more of: glass or silicon; and
wherein at least one of the plurality of trenches has a cross section at a plane parallel to the first side of the substrate that includes a selected one or more of: a circle, an ellipse, a square, a rectangle, or a pill shape.

15. The method of claim 12, wherein prior to forming the plurality of first electrical conductors, the method further comprising forming a plurality of barrier layers, respectively, within the plurality of trenches.
